# EUROPÄISCHE PATENTSCHRIFT

(11) **EP 0 342 745 B1**
(45) Veröffentlichungstag und Bekanntmachung des Hinweises auf die Patenterteilung: **20.12.1995**
(21) Anmeldenummer: 89201194.1
(22) Anmeldetag: 12.05.1989
(51) Int. Cl.: G01R 33/34, G01R 33/36

(54) **Kernspinuntersuchungsgerät mit einer Hochfrequenzspulenanordnung**
Nuclear spin examining apparatus with a radio frequency coil arrangement
Appareil d'examen à spin nucléaire comportant un agencement de bobines à haute fréquence

(30) Priorität: 18.05.1988 DE 3816831
(43) Veröffentlichungstag der Anmeldung: 23.11.1989
(73) Patentinhaber: Philips Patentverwaltung GmbH, 22335 Hamburg (DE); Philips Electronics N.V., 5621 BA Eindhoven (NL)
(72) Erfinder: Leussler, Christoph Günther, D-2000 Hamburg 20 (DE)
(74) Vertreter: Hartmann, Heinrich, Dipl.-Ing.

(56) Entgegenhaltungen:
- EP-A- 0 142 760
- EP-A- 0 200 078
- EP-A- 0 273 484
- EP-A- 0 281 787
- US-A- 4 733 190
- SOCIETY OF MAGNETIC RESONANCE IN MEDICINE, SEVENTH ANNUAL MEETING AND EXHIBITION, San Francisco, CA, 20. - 26. August 1988; L. LI et al.: "A highly efficient double-tuned resonator for phosphorus-31 imaging in Ex-Vivo bone"
- JOURNAL OF MAGNETIC RESONANCE, Band 78, Nr. 1, 1. Juni 1988, Seiten 69-76, Duluth, MN, US; P.L. KUHNS et al.: "Inductive coupling and tuning in NMR probes; Applications"
- Book of Abstracts, SMRM, 6th Annual Meeting, Aug. 1987, Seite 96, S.M.Wright et al. "Arrays of Mutually Coupled Local Coils for High Resolution MR Imaging"
- Magn.Res.Med. 6 (März 1988) Seiten 253-264
- Radiology 160 (1986) Seiten 695-699

## Beschreibung

Die Erfindung betrifft ein Kernspinuntersuchungsgerät mit einer Hochfrequenzspulenanordnung nach dem Oberbegriff des Anspruchs 1. Eine solche Hochfrequenzspulenanordnung ist beispielsweise aus Radiology 160 (1986) S.695-699 bekannt.

Es ist bekannt, daß das Signal-Rausch-Verhältnis beim Empfang von Kernspinresonanzsignalen umso ungünstiger wird, je niedriger die Magnetflußdichte des stationären homogenen Magnetfeldes ist, dem der Untersuchungsbereich bei einer Kernspinuntersuchung ausgesetzt ist. Um auch bei Kernspinresonanzgeräten mit niedriger Magnetflußdichte noch ein akzeptables Signalrauschverhältnis zu erreichen, ist es wichtig, daß die Hochfrequenzspulenanordnung, die die Kernspinresonanzsignale aufnimmt, eine hohe Güte und eine hohe Empfindlichkeit aufweist. Es ist bekannt, daß eine sogenannte Solenoid-Spule mit einer genügenden Anzahl von Windungen diese Eigenschaften aufweist. Jedoch kann die Windungszahl nur so groß gewählt werden, daß die Länge des Leiters, aus dem diese Spule gewickelt ist, kleiner ist als eine Viertel Wellenlänge der Betriebsfrequenz, vorzugsweise klein im Vergleich dazu.

Murton und Neale haben daher eine Spulenanordnung beschrieben, bei der zwei Spulen mit je drei Windungen parallel geschaltet sind. Auch hier liegt die Eigenresonanzfrequenz aufgrund unvermeidbarer Spulenkapazitäten noch relativ niedrig, so daß sich Wellenausbreitungseffekte bemerkbar machen können, die zu einer Zunahme der dielektrischen Verluste und damit zu einer Abnahme der Güte führen.

Aufgabe der vorliegenden Erfindung ist es, eine Hochfrequenzspulenanordnung für ein Kernspinresonanzgerät zu schaffen, die auch bei vergleichsweise niedriger Kernspinresonanzfrequenz einen günstigen Signal-Rausch-Abstand und eine hohe Güte aufweist. Diese Aufgabe wird durch die im Hauptanspruch angegebenen Maßnahmen gelöst.

Die Erfindung verwendet also mehr als zwei in parallelen Ebenen auf dem Umfang eines hohlzylinderförmigen Trägerkörpers angeordnete Resonatoren, die jeweils durch eine Leiterschleife gebildet werden, die in der Regel mittels eines zusätzlichen Kondensators auf die gleiche Frequenz abgestimmt sind. Die einzelnen Resonatoren sind galvanisch nicht miteinander verbunden, sondern induktiv miteinander gekoppelt. Nur einer der Resonatoren ist im Betrieb an den Hochfrequenzsender bzw. an den Hochfrequenzempfänger angeschlossen. Eine derartige Hochfrequenzspulenanordnung verhält sich daher hinsichtlich der Wellenausbreitungseffekte und der damit verbundenen dielektrischen Verluste wie eine Hochfrequenzspule mit nur einer Windung, hinsichtlich der Empfindlichkeit jedoch wie eine Solenoid-Spule, deren Windungszahl der Zahl der Resonatoren entspricht.

Es sei an dieser Stelle erwähnt, daß aus der EP-A 281 787 bereits ein Oberflächenresonator für Kernspinuntersuchungsgeräte bekannt ist, der aus zwei in etwa der gleichen Ebene angeordneten Windungen besteht, die galvanisch miteinander verbunden sind und induktiv miteinander gekoppelt sind, wobei der Signalabgriff und die Signaleinspeisung an den Enden einer Windung erfolgt. Weiterhin ist angegeben, daß man je einen dieser Oberflächenresonatoren oberhalb und unterhalb des Untersuchungsbereichs anordnen kann.

Außerdem ist aus der EP-B 142 760 eine MR-Spulenanordnung bekannt, die aus einem oberen und einem unteren Teil mit je einem Resonator besteht. Die Resonatoren sind miteinander induktiv gekoppelt, und nur einem der Resonatoren wird Energie zugeführt. Die beiden Resonatoren sind in der oberen und unteren Hälfte eines zylinderförmigen Trägerkörpers angeordnet, wobei das Feld senkrecht zur Zylinderachse verläuft, während es bei der Erfindung in Richtung der Zylinderachse verläuft.

Bei einer erfindungsgemäßen Hochfrequenzspulenanordnung gibt es so viele Schwingungsmoden wie es Resonatoren gibt. Bei einem Schwingungsmodus fließen die Ströme in sämtlichen Resonatoren mit dem gleichen Umlaufsinn. Dieser Schwindungsmodus ist mit der niedrigsten Resonanzfrequenz verknüpft, die unterhalb der Frequenz liegt, auf die die einzelnen Resonatoren abgestimmt sind. Bei einem anderen Schwingungsmodus haben die Ströme in räumlich benachbarten Resonatoren immer den entgegengesetzten Umlaufsinn. Bei diesem Schwingungsmodus ergibt sich die höchste Resonanzfrequenz, die oberhalb der Frequenz liegt, auf die die Resonatoren abgestimmt sind. Dieser Schwingungsmodus kann nur dadurch angeregt werden, daß einem der Resonatoren ein Strom mit der betreffenden Frequenz zugeführt wird; durch ein äußeres homogenes Hochfrequenzfeld kann er hingegen nicht hervorgerufen werden. Bei Verwendung einer erfindungsgemäßen Hochfrequenzspulenanordnung zum Empfang von Kernspinresonanzsignalen kann diese daher vollständig von einer Sendespule entkoppelt werden, die auf der gleichen Resonanzfrequenz arbeitet.

In Ausgestaltung der Erfindung ist vorgesehen, daß im Betriebszustand ein senkrecht verlaufendes homogenes stationäres Magnetfeld auf den von der Hochfrequenzspulenanordnung umschlossenen Untersuchungsbereich einwirkt. In einem Kernspintomographen wird ein Patient in der Regel liegend untersucht. Die Hochfrequenzspulenanordnung hat dann also eine horizontal verlaufende Längsachse und erzeugt ein in diese Richtung verlaufendes hochfrequentes Magnetfeld, zu dem das vertikale, homogene und stationäre Magnetfeld senkrecht steht - wie es erforderlich ist.

Die Erfindung wird nachstehend anhand der Zeichnung näher erläutert. Es zeigen:
Fig. 1 einen Kernspintomographen, bei dem die Erfindung anwendbar ist.
Fig. 2 ein elektrisches Prinzipschaltbild und
Fig. 3 die räumliche Gestaltung einer erfindungsgemäßen Hochfrequenzspule.
Fig. 4 eine Modifikation dieser Spule.

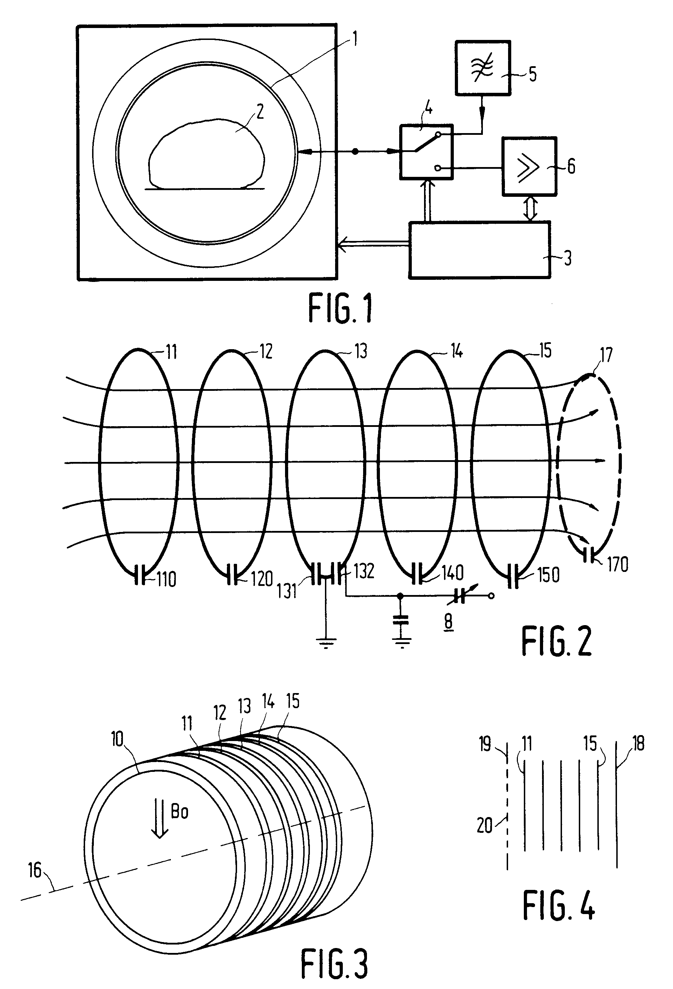

Der in Fig. 1 dargestellte Kernspintomograph enthält eine Hochfrequenzspulenanordnung 1 mit hohlzylindrischem Querschnitt, die in ihrem Innern ein zur Zeichenebene senkrechtes, hochfrequentes Magnetfeld erzeugt, das den Untersuchungsbereich durchsetzt, in dem sich das Untersuchungsobjekt 2 befindet, beispielsweise ein Patient, dessen Längsachse senkrecht zur Zeichenebene verläuft. Der Kernspintomograph besitzt einen nicht näher dargestellten Hauptfeldmagneten, der ein in vertikaler Richtung verlaufendes stationäres homogenes Magnetfeld mit einer Magnetflußdichte von einigen Zehntel T oder weniger erzeugt. Das stationäre Magnetfeld und das Hochfrequenzfeld stehen also senkrecht zueinander. Daneben gibt es noch Gradientenspulen - ebenfalls nicht näher dargestellt - die ebenfalls in vertikaler Richtung verlaufende Magnetfelder erzeugen, jedoch mit einem Gradienten in jeweils einer von drei zueinander senkrecht stehenden Richtungen.

Eine Steuereinheit 3 steuert die Erzeugung der zuvor beschriebenen Felder und verarbeitet die aus dem Untersuchungsbereich empfangenen Kernspinresonanzsignale. Insbesondere wirkt sie auf einen elektronischen Umschalter 4 ein, mittels dessen die Hochfrequenzspulenanordnung 1 von Sendebetrieb - in dem sie mit einem Oszillator 5 verbunden ist - auf Empfangsbetrieb umgeschaltet wird, in dem sie mit einem Hochfrequenzempfänger 6 verbunden ist, der die Kernresonanzsignale verstärkt, demoduliert und in eine Folge digitaler Datenworte umsetzt, die in der Einheit 3 verarbeitet werden.

Wie sich aus den Fig. 2 und 3 ergibt, besteht die Hochfrequenzspulenanordnung 1 aus einer Anzahl von Resonatoren 11 ... 15. Die Resonatoren sind auf einem zylinderförmigen Trägerkörper 10 angeordnet, dessen Mittelachse 16 senkrecht zu dem homogenen stationären Magnetfeld B₀ verläuft. Jeder Resonator umfaßt eine Leiterschleife, die den Trägerkörper ringförmig umschließt und nur an einer Stelle unterbrochen wird, die kapazitiv überbrückt ist. Die Leiterschleifen befinden sich in parallelen, zur Längsachse 16 des Trägerkörpers 10 vorzugsweise senkrechten Ebenen. Die Kapazität der die offenen Enden der Leiterschleifen 11 .. 15 überbrückenden Kondensatoren 110 ... 150 ist so gewählt, daß alle Resonatoren (für sich allein) auf dieselbe Resonanzfrequenz abgestimmt sind. Bei der mittleren Leiterschleife 13 erfolgt diese Abstimmung mittels zweier gleich großer, in Serie geschalteter Kondensatoren 131 und 132, deren Verbindungspunkt geerdet ist. Der von diesem Verbindungspunkt abgewandte Anschluß eines der beiden Kondensatoren (132) ist über ein Anpaß- und Abstimmnetzwerk 8 mit dem Umschalter 4 (Fig. 1) verbunden.

Anstatt an jeweils einer Stelle können die Leiterschleifen auch an mehreren auf dem Umfang jeweils gleichmäßig gegeneinander versetzten Stellen unterbrochen und durch einen Kondensator mit geeigneter Kapazität überbrückt sein. Dadurch vergrößert sich zwar der Aufwand, doch werden dadurch die im Betrieb auftretenden dielektrischen Verluste noch weiter reduziert bzw. die Güte noch weiter vergrößert.

Die durch eine Leiterschleife und einen bzw. zwei Kondensatoren gebildeten Resonatoren sind nicht galvanisch miteinander verbunden. Sie sind jedoch induktiv miteinander gekoppelt, weil die Leiterschleifen sich in parallelen Ebenen befinden. Wegen der fehlenden galvanischen Verbindung zwischen den einzelnen Leiterschleifen werden die Ausbreitungseffekte lediglich durch die Abmessungen der mit dem Hochfrequenzsender 5 bzw. dem Hochfrequenzempfänger 6 koppelbaren Leiterschleife 13 bestimmt. Bei einem Durchmesser des Rohres 10 von 600 mm ist die Länge einer solchen Leiterschleife (knapp 2 m) aber immer noch klein im Vergleich zu einem Viertel der Wellenlänge (35 m), die sich bei einer Magnetflußdichte des stationären homogenen Magnetfeldes B₀ von 0,2 T und der damit verbundenen Kernspinresonanzfrequenz von rund 8,5 MHz ergibt. Auf der anderen Seite resultiert aus der induktiven Kopplung zwischen den verschiedenen Resonatoren eine Konzentration des erzeugten Magnetfeldes, das in Richtung der Mittelachse 16 bzw. senkrecht zur Ebene der Resonatoren verläuft, wie in Fig. 2 angedeutet, im wesentlichen in dem von den Resonatoren umschlossenen Raum - ähnlich wie bei einer Solenoid-Spule mit einer entsprechenden Anzahl von Windungen. Die Güte und insbesondere die Spulenempfindlichkeit sind daher umso besser, je mehr Resonatoren vorhanden sind. In der Praxis wird man daher auch mehr als nur die in den Figuren dargestellten fünf Resonatoren verwenden.

Neben der starken Feldkonzentration, insbesondere im Zentrum (im Bereich des Resonators 13), besteht ein weiterer Vorteil in der ausgezeichneten Homogenität des Hochfrequenzfeldes im Innern der Spule.

Bei einer aus mehreren Resonatoren bestehenden Hochfrequenzspulenanordnung entspricht die Zahl der Resonanzfrequenzen der Zahl der Resonatoren; als Resonanzfrequenz ist dabei diejenige Frequenz bezeichnet, bei der das Verhältnis der Energie im Resonator zu der dem Resonator zugeführten Energie ein Maximum hat. Die Resonanzfrequenzen liegen umso weiter auseinander, je stärker die induktive Kopplung zwischen den einzelnen Resonatoren ist, d.h. je dichter die Leiterschleifen beieinander liegen. Jede Resonanzfrequenz ist mit einem anderen Schwingungsmodus verknüpft. Die niedrigste Resonanzfrequenz ergibt sich, wenn in allen Resonatoren ein Strom mit gleichem Umlaufsinn fließt. Diese Resonanzfrequenz ist niedriger als die Frequenz, auf die die einzelnen Resonatoren abgestimmt sind. Die höchste Resonanzfrequenz ergibt sich, wenn der Umlaufsinn des Stromes von Resonator zu Resonator umgekehrt ist; diese Frequenz ist wesentlich höher als die Frequenz, auf die die Resonatoren abgestimmt sind. Der Vorteil dieses Schwingungsmodus ist, daß er durch ein homogenes äußeres Magnetfeld nicht angeregt werden kann. Wenn man eine solche Spulenanordnung als Empfangsspule im Feld einer (zusätzlichen) Sendespule betreibt, ergibt sich eine weitgehende Entkopplung zwischen den Spulen, insbesondere, wenn die Empfangsspule aus einer geraden Anzahl von Resonatoren besteht. Dabei ist von Vorteil, daß herkömmliche Sendespulen meist ebenfalls auf einem Zylindermantel liegen, aber ein zur Zylinderachse senkrechtes Feld erzeugen. Die Empfangsspule kann also konzentrisch zur Sendespule in deren Inneren angeordnet sein.

Bei einem in der Praxis untersuchten Ausführungsbeispiel einer Hochfrequenzspule für Kernspinuntersuchungen im Kopfbereich wurden auf einen Trägerkörper mit einem Durchmesser von 320 mm sieben Resonatoren aufgebracht. Jeder Resonator bestand aus 12 mm starkem Kupferrohr, das mittels eines Kondensators von 320 pF auf eine Frequenz von etwa 11 MHz abgestimmt war. Der Abstand der Leiterschleifen betrug 20 mm. Diese Anordnung wurde bei der niedrigsten Resonanzfrequenz betrieben, die bei 6,8 MHz lag. Hier ergab sich eine Leerlaufgüte von 120 und eine belastete Güte von etwa 280. Sattelspulen weisen bei solchen Resonatorfrequenzen zwar ähnlich hohe Leerlauf- und Betriebsgüten auf, so daß sie im Sendebetrieb nicht unterlegen sind. Jedoch ist die Empfindlichkeit einer Sattelspule um rund 40 % niedriger,so daß die erfindungsgemäße Hochfrequenzspulenanordnung im Empfangsbetrieb wesentliche Vorteile aufweist. Zu niedrigen Frequenzen hin nimmt die Güte einer Hochfrequenzspulenanordnung nach der Erfindung weitaus weniger ab als die einer Sattelspule, so daß sich bei noch niedrigern Frequenzen also auch hinsichtlich des Sendebetriebes Vorteile ergeben.

Vorstehend wurde eine Hochfrequenzspule mit kreisförmigem Querschnitt beschrieben. Die Hochfrequenzspule kann aber auch einen anderen Querschnitt haben, beispielsweise einen elliptischen oder einen quadratischen. Die Mittelpunkte bzw. die Flächenschwerpunkte der von den einzelnen Leiterschleifen umschlossenen Flächen sollten dabei auf einer gemeinsamen Geraden liegen, und die zueinander parallelen Ebenen, in denen sich die Leiterschleifen befinden, sollten diese Gerade möglichst senkrecht schneiden.

Es ist nicht erforderlich, daß alle Leiterschleifen die gleiche Größe haben. Wie in Fig. 2 gestrichelt angedeutet, kann eine weitere Leiterschleife 17 vorgesehen sein, die konzentrisch zur Mittelachse 16 angeordnet ist und die einen geringeren Durchmesser aufweist als diese. Diese Leiterschleife muß auf die gleiche Frequenz abgestimmt sein wie die anderen Resonatoren, wozu aber wegen der verringerten Induktivität dieser Schleife ein Kondensator 170 mit größerer Kapazität erforderlich ist. Die Wirkung dieses kleineren Resonators 17, der sich an dem einen Ende der Hochfrequenzspulenanordnung befindet, äußert sich darin, daß die Magnetflußdichte in axialer Richtung nach außen hin noch stärker abfällt, so daß das magnetische Feld noch stärker in dem von den Spulen umschlossenen Raum konzentriert wird. Wenn dann der Generator bzw. der Empfänger nicht an den mittleren Resonator 13 sondern an den der Spule 17 benachbarten Resonator 15 angeschlossen wird, ergibt sich auch zur anderen Seite der Spule hin eine stärkere Abnahme des Magnetfeldes. Bei der Benutzung einer derartigen Hochfrequenzspule als Kopfspule ergeben sich insofern Vorteile, als dem dann links vom Resonator 11 befindlichen Hals- und Schulterbereich weniger Hochfrequenzenergie zugeführt wird und dieser Bereich die Spulengüte daher weniger belastet.

In Fig. 4 ist an der von der Patienteneintrittsseite abgewandten Seite der Spule ein zur Spulenachse senkrechter leitfähiger Schirm 18 aus einer 30»m dicken Kupferfolie angeordnet. Dieser erhöht das Feld im Zentrum der Spule, bewirkt also zusätzlich eine Feldkonzentration und damit ein besseres Signal-Rausch-Verhältnis.

Zusätzlich kann - bei Verwendung als Kopfspule - auf der Seite der Spule, auf der der Patient mit seinem Kopf eingeführt wird, ein weiterer Schirm 19 angeordnet werden, der mit einer Öffnung - in Fig. 4 mit 20 gestrichelt angedeutet - für den Patientenkopf versehen ist. Dieser schirmt den Schulterbereich des Patienten und Streufelder ab, welche eine zusätzliche Patientenbelastung erzeugen.

## Patentansprüche

1. Kernspinuntersuchungsgerät mit einer Hochfrequenzspulenanordnung, die an einen Hochfrequenzsender und/oder an einen Hochfrequenzempfänger anschließbar ist, und mehr als zwei, gleichzeitig im Sendebetrieb oder im Empfangsbetrieb wirksame, auf die gleiche Frequenz abgestimmte und in parallelen Ebenen angeordnete Resonatoren aufweist, von denen jeder eine ein- oder mehrteilige Leiterschleife (11...15) umfaßt, deren Enden kapazitiv miteinander gekoppelt sind,
dadurch gekennzeichnet, daß die Resonatoren auf dem Umfang eines hohlzylinderförmigen Trägerkörpers (10) angeordnet sind, daß nur einer der Resonatoren (13) an den Hochfrequenzsender (3) bzw. an den Hochfrequenzempfänger (6) angeschlossen ist, und daß die Resonatoren induktiv, aber nicht galvanisch miteinander gekoppelt sind.

2. Kernspinuntersuchungsgerät nach Anspruch 1,
dadurch gekennzeichnet, daß ein weiterer Resonator die gleiche Form aber eine geringere Größe hat wie die übrigen Resonatoren.

3. Kernspinuntersuchungsgerät nach einem der vorhergehenden Ansprüche,
dadurch gekennzeichnet, daß die Sende- bzw. die Empfangsfrequenz der am niedrigsten liegenden Resonanzfrequenz der Hochfrequenzspulenanordnung entspricht.

4. Kernspinuntersuchungsgerät nach Anspruch 1,
dadurch gekennzeichnet, daß die Sende- bzw. die Empfangsfrequenz der am höchsten liegenden Resonanzfrequenz der Hochfrequenzspulenanordnung entspricht.

5. Kernspinuntersuchungsgerät nach Anspruch 4,
dadurch gekennzeichnet, daß die Hochfrequenzspulenanordnung durch eine gerade Zahl von Resonatoren gebildet wird.

6. Kernspinuntersuchungsgerät nach einem der vorhergehenden Ansprüche,
dadurch gekennzeichnet, daß im Betriebszustand ein senkrecht verlaufendes homogenes stationäres Magnetfeld (B₀) auf den von der Hochfrequenzspulenanordnung (1) umschlossenen Untersuchungsbereich einwirkt.

7. Kernspinuntersuchungsgerät nach einem der vorhergehenden Ansprüche,
dadurch gekennzeichent, daß die Hochfrequenzspulenanordnung (11...15) zum Signalempfang dient und im Innern einer dazu konzentrischen Sendespule angeordnet ist, deren Hochfrequenzfeld senkrecht zur Spulenachse verläuft.

8. Kernspinuntersuchungsgerät nach einem der vorherigen Ansprüche,dadurch gekennzeichnet, daß an wenigstens einem der Spulenenden ein leitfähiger Schirm (18,1a) angeordnet ist.

9. Kernspinuntersuchungsgerät nach Anspruch 8,
dadurch gekennzeichnet, daß der Schirm auf der Patienteneintrittsseite eine Öffnung (20) aufweist.

## Claims

1. A magnetic resonance examination apparatus, comprising an RF coil system which is connectable to an RF transmitter and/or an RF receiver, and more than two resonators which operate simultaneously in the transmission mode or the receiving mode, are tuned to the same frequency, and are arranged in parallel planes, each resonator comprising a conductor loop (11 ... 15) which consists of one or more parts and whose ends are capacitively coupled to one another, characterized in that the resonators are arranged on the circumference of a hallon-cylindrical, supporting body (10), that only one resonator (13) is connected to the RF transmitter (3) or to the RF receiver (6), and that the resonators are inductively but not conductively complex to one another.

2. A magnetic resonance examination apparatus as claimed in Claim 1, characterized in that a further resonator has the same shape as but smaller dimensions than the other resonators.

3. A magnetic resonance examination apparatus as claimed in any one of the preceding Claims, characterized in that the transmission frequency or the receiving frequency corresponds to the lowest resonance frequency of the RF coil system.

4. A magnetic resonance examination apparatus as claimed in Claim 1, characterized in that the transmission frequency or the receiving frequency corresponds to the highest resonance frequency of the RF coil system.

5. A magnetic resonance examination apparatus as claimed in Claim 4, characterized in that the RF coil system is formed by an even number of resonators.

6. A magnetic resonance examination apparatus as claimed in any one of the preceding Claims, characterized in that in the operating condition a perpendicularly extending uniform, steady magnetic field (B0) acts on the examination zone enclosed by the RF coil system (1).

7. A magnetic resonance examination apparatus as claimed in any one of the preceding Claims, characterized in that the RF coil system (11 ... 15) serves for signal reception and is arranged inside a transmitter coil so as to be concentric therewith, the RF field of said transmitter coil extending perpendicularly to the coil axis.

8. A magnetic resonance examination apparatus as claimed in any one of the preceding Claims, characterized in that a conductive shield (18, 1a) is arranged at least at one of the coil ends.

9. A magnetic resonance examination apparatus as claimed in Claim 8, characterized in that the shield comprises an opening (20) at the side where the patient is introduced.

## Revendications

1. Appareil d'examen à spin nucléaire comprenant un agencement de bobines de haute fréquence qui peut être connecté à un émetteur à haute fréquence et/ou à un récepteur à haute fréquence et plus de deux résonateurs simultanément actifs dans un mode émission ou en mode réception, accordés sur la même fréquence et disposés dans des plans parallèles, chacun d'eux comprend une boucle de conducteur (11 ... 15) en une ou plusieurs parties, dont les extrémités sont couplées capacitivement, caractérisé en ce que les résonateurs sont agencés sur le contour d'un corps de support cylindrique creux (10), que seul l'un des résonateurs (13) est connecté à l'émetteur à haute fréquence (3) ou au récepteur à haute fréquence (6) et que les résonateurs sont couplés inductivement, mais ne sont pas reliés galvaniquement entre eux.

2. Appareil d'examen à spin nucléaire suivant la revendication 1, caractérisé en ce qu'un résonateur supplémentaire a la même forme, mais une dimension plus petite que les autres résonateurs.

3. Appareil d'examen à spin nucléaire suivant l'une quelconque des revendications précédentes, caractérisé en ce que la fréquence d'émission ou de réception correspond à la fréquence de résonance la plus basse de l'agencement de bobines à haute fréquence.

4. Appareil d'examen à spin nucléaire suivant la revendication 1, caractérisé en ce que la fréquence d'émission ou de réception correspond à la fréquence de résonance la plus élevée de l'agencement de bobines à haute fréquence.

5. Appareil d'examen à spin nucléaire suivant la revendication 4, caractérisé en ce que l'agencement de bobines à haute fréquence est formé par un nombre pair de résonateurs.

6. Appareil d'examen à spin nucléaire suivant l'une quelconque des revendications précédentes, caractérisé en ce que dans l'état de fonctionnement, un champ magnétique homogène statique (B₀) qui est orienté verticalement agit sur le domaine d'examen entouré par l'agencement de bobines à haute fréquence (1).

7. Appareil d'examen à spin nucléaire suivant l'une quelconque des revendications précédentes, caractérisé en ce que l'agencement de bobines à haute fréquence (11 ... 15) sert à la réception de signaux et est disposé à l'intérieur d'une bobine émettrice qui lui est concentrique et dont le champ de haute fréquence est perpendiculaire à l'axe des bobines.

8. Appareil d'examen à spin nucléaire suivant l'une quelconque des revendications précédentes, caractérisé en ce qu'un écran conducteur (18, 19) est monté à au moins l'une des extrémités des bobines.

9. Appareil d'examen à spin nucléaire suivant la revendication 8, caractérisé en ce que l'écran comprend un orifice (20) du côté de l'accès du patient.
